# EUROPÄISCHE PATENTSCHRIFT

(11) **EP 1 352 985 B1**
(45) Veröffentlichungstag und Bekanntmachung des Hinweises auf die Patenterteilung: **04.01.2006**
(21) Anmeldenummer: 02008046.1
(22) Anmeldetag: 10.04.2002
(51) Int. Cl.: C23C 4/10, C23C 14/06, C23C 16/30, C23C 14/08

(54) **Wärmedämmschichtsystem**
Thermal barrier coating system
Système de revêtement de barrière thermique

(43) Veröffentlichungstag der Anmeldung: 15.10.2003
(60) Teilanmeldung: 04015804.0
(73) Patentinhaber: SIEMENS AKTIENGESELLSCHAFT, 80333 München (DE)
(72) Erfinder: Bast, Ulrich Dr., 81667 Muenchen (DE); Greil, Peter, Prof., 91085 Weisendorf (DE); Müller, Frank, 91207 Lauf (DE)

(56) Entgegenhaltungen:
- EP-A- 0 979 881
- EP-A- 1 249 515
- WO-A-01/18274
- WO-A-01/43965
- WO-A-99/23271
- WO-A-99/42630
- US-A- 4 814 575
- US-A- 5 849 416
- US-A- 6 093 454
- PATENT ABSTRACTS OF JAPAN vol. 006, no. 040 (C-094), 12. März 1982 (1982-03-12) & JP 56 156754 A (MITSUBISHI HEAVY IND LTD), 3. Dezember 1981 (1981-12-03)
- CUKAUSKAS E J ET AL: "Y1BA2CU3O7-X AND LAAIO3 COMPOSITE THIN FILMS BY OFF-AXIS MAGNETRON SPUTTERING" APPLIED PHYSICS LETTERS, AMERICAN INSTITUTE OF PHYSICS. NEW YORK, US, Bd. 60, Nr. 3, 20. Januar 1992 (1992-01-20), Seiten 389-391, XP000297642 ISSN: 0003-6951
- DATABASE WPI Section Ch, Week 199431 Derwent Publications Ltd., London, GB; Class L02, AN 1994-253274 XP002231551 & JP 06 184750 A (KYOCERA CORP), 5. Juli 1994 (1994-07-05)

## Beschreibung

Die Erfindung betrifft ein Wärmedammschichtsystem, das aus einem Substrat und darauf aufliegenden Schichten besteht.

Aus der EP 1 029 101 B1 ist eine Wärmedämmschicht bekannt, wobei die keramische äußere Schicht die Materialzusammensetzung La-Al-Gd-O oder Sr-Ca-Zr-O aufweist.

Die US 5,545,484 weist ein Schichtsystem auf, bei dem das Substrat durch Fasern mechanisch verstärkt ist.

Die Wärmedämmschichten sind im wesentlichen Funktionsschichten und sollen das Substrat beispielsweise vor zu großer Wärme schützen. Das Substrat weist eine hinreichend große mechanische Festigkeit auf. Die Wärmedämmschichten sind ebenfalls thermischen Spannungen oder mechanischen Spannungen ausgesetzt und können durch Abplatzen versagen, weil Risse entstehen.

Es ist daher Aufgabe der Erfindung ein Wärmedämmschichtsystem und ein Verfahren zum Herstellen dieser aufzuzeigen, bei dem die Schichten thermischen und mechanischen Spannungen besser standhalten können.

Die Aufgabe wird durch ein Wärmedämmschichtsystem gemäß Anspruch 1 gelöst. Dabei wird in die zumindest eine Schicht aus La-Al-O, Sr-Ca-Zr-O oder Gd-La-Al-O eine Zweitphase eingebracht; die die Schicht in ihren mechanischen Eigenschaften verbessert.

In den Unteransprüchen 2 bis 14 sind weitere vorteilhafte Verbesserungen des Wärmedämmschichtsystems aufgelistet, wodurch die mechanische Festigkeit (Biege-, Druck-,..) und Bruchzähigkeit (K₁^{c}) verbessert wird.

Die Zweitphase kann in Form von Fasern oder Partikeln vorhanden sein. Als Fasern kommen herkömmliche Kohlestofffasern oder Fasern aus anderem Material bzw. Whisker in Frage.

Die Partikel, die die Zweitphase bilden, können die gleichen Elemente wie das Matrixmaterial der Schicht aufweisen oder aber auch aus einem anderen Materialsystem gewählt sein.

Wenn die Partikel länglich sind, d.h. ein hohes Verhältnis von Länge zu Querschnittsfläche aufweisen (großes aspectratio) wird die Schicht bzw. das Matrixmaterial der Schicht, durch Rissumlenkung und/oder Rissverzweigung vorteilhaft verstärkt.

Als zu verstärkende Schicht kann eine keramische oder metallische Schicht, der auf dem Substrat aufliegenden Schichten gewählt werden. Insbesondere ist dies die Wärmedämmschicht.

Ausführungsbeispiele sind in den nachfolgenden Figuren gezeigt.

Es zeigen:
Figur 1 eine Turbinenschaufel,
Figur 2 ein Wärmedämmschichtsystem,
Figur 3 eine schematische Darstellung der Mikrostruktur einer Schicht des erfindungsgemäßen Wärmedämmschichtschichtsystems und
Figur 4 schematisch eine Beschichtungsvorrichtung, um die erfindungsgemäßen Verfahren durchführen zu können, und
Figuren 5, 6 weitere Ausführungsbeispiele der erfindungsgemäßen Wärmedämmschicht.

Gleiche Bezugszeichen haben in den verschiedenen Figuren die gleiche Bedeutung.

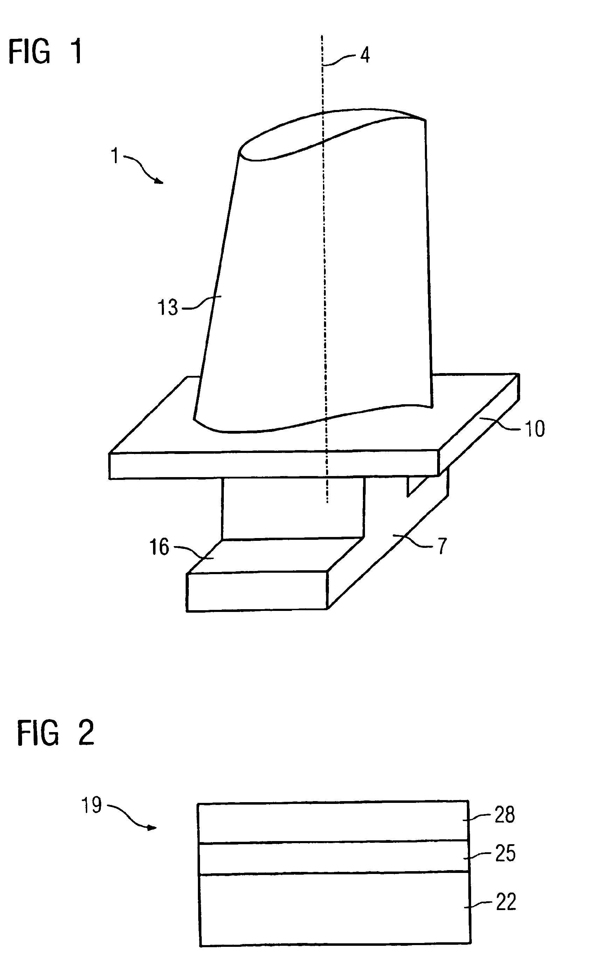

Figur 1 zeigt in perspektivischer Ansicht eine Laufschaufel 1, die sich entlang einer Längsachse 4 erstreckt.
Die Laufschaufel 1 weist entlang der Längsachse 4 aufeinanderfolgend einen Befestigungsbereich 7, eine daran angrenzende Schaufelplattform 10 sowie einen Schaufelblattbereich 13 auf.

Im Befestigungsbereich 7 ist ein Schaufelfuß 16 gebildet, der zur Befestigung der Laufschaufel 1 an einer nicht dargestellten Welle einer ebenfalls nicht dargestellten Strömungsmaschine dient. Der Schaufelfuß 16 ist beispielsweise als Hammerkopf ausgestaltet. Andere Ausgestaltungen sind möglich. Bei herkömmlichen Laufschaufeln werden in allen Bereichen 7, 10, 13 und 16 massive metallische Werkstoffe verwendet. Die Laufschaufel 1 kann hierbei durch ein Gussverfahren, durch ein Schmiedeverfahren, durch ein Fräsverfahren oder Kombinationen daraus gefertigt sein.
Insbesondere im Schaufelblattbereich 13, der höheren Temperaturen beispielsweise einer Gasturbine ausgesetzt ist, ist zumindest eine Schicht, insbesondere eine Oxidations-/Korrosionsschutzschicht und Wärmedämmschicht, aufgebracht, die Teil eines Wärmedämmschichtsystems ist.

Figur 2 zeigt ein solches erfindungsgemäßes Wärmedämmschichtsystem 19.
Das Wärmedämmschichtsystem 19 weist ein Substrat 22 auf, beispielsweise eine Nickel- oder Cobalt- basierte Superlegierung auf der beispielsweise zumindest eine Zwischenschicht 25 aufgebracht ist.

Die Zwischenschicht 25 kann aus mehreren Schichten bestehen, die beispielsweise als Diffusionsbarriere, als Haftvermittlerschicht (MCrAlY, M= Fe, Co, Ni), Korrosionsschutzschicht oder als Verankerungsschicht dienen.

Auf dem Substrat 22 oder auf der zumindest einen Zwischenschicht 25 ist beispielsweise eine keramische Wärmedämmschicht 28 aufgebracht.
Die zumindest eine Zwischenschicht 25 und die Wärmedämmschicht 28 sind mechanischen Belastungen ausgesetzt.

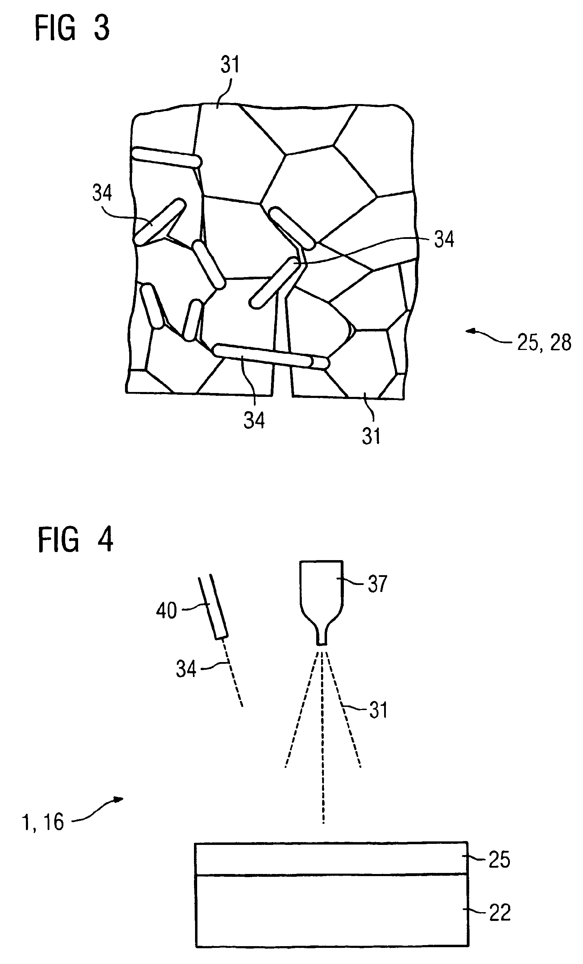

Figur 3 zeigt schematisch eine Mikrostruktur der Zwischenschicht 25 oder der Wärmedämmschicht 28.

Die erfindungsgemäße Schicht 25, 28 besteht aus einer Matrix 31 und einer Zweitphase 34. Die Matrix 31 besteht aus Körnern, die verschiedene Formen (Morphologien) aufweisen können. Wird die Matrix 31 beispielsweise durch Plasmaspritzen hergestellt, so weisen die Körner des Matrixmaterials 31 eine plättchenförmige Gestalt auf. Die Zweitphase 34 kann beim Plasmaspritzen mit dem Matrixmaterial 31 bspw. vermischt sein und zusammen durch eine Brennerdüse (Fig. 4) aufgetragen werden.

Die Zweitphase 34 kann eine andere Phase des Matrixmaterials 31, aber auch eine Faser oder ein Whisker sein.

Die Zweitphase 34 hat die Aufgabe die mechanische Festigkeit der Matrix 31 zu verstärken. Dies kann durch Faserverstärkung oder Partikelverstärkung mit den bekannten Verstärkungsmechanismen gewährleistet sein. Insbesondere, wenn die Zweitphase 34 eine längliche Form aufweist, wird die mechanische Festigkeit der Matrix 31 besonders erhöht.

Als Material 31 für die Wärmedämmschicht 28 werden die in der EP 1 029 101 B1 offenbarten Materialien verwendet, d.h. die Systeme La₁₋ₓ Gdₓ AlO₃ oder Ca₁₋ₓ Srₓ ZrO2₃. Die EP 1 029 101 B1 soll insbesondere Teil der Offenbarung der vorliegenden Anmeldung sein. Die Elemente Gd und La können durch andere Lanthanide ersetzt sein.

Als Zweitphase 34 zur Verstärkung der Matrix 31 für das Matrixmaterial 31 Gd-La-Al-O wird insbesondere die Zweitphase 34 mit der Zusammensetzung LaAl₁₁O₁₈ (β-Aluminat) verwendet.

Die Schicht 25, 28 kann durch verschiedene Beschichtungsverfahren wie z.B. Plasmaspritzen, CVD- oder PVD-Verfahren hergestellt werden.

Beim Plasmaspritzen kann die Zweitphase 34 mit dem Matrixmaterial 31 vermischt werden und durch die Brennerdüse auf das Substrat 22 oder die Zwischenschicht 25 aufgebracht werden.

Es kann jedoch bei bestimmten Zweitphasen 34 der Fall auftreten, dass die Zweitphase bei den hohen Temperaturen des Plasmaspritzens nicht phasenstabil ist. Ebenso kann es bei den CVD- oder PVD-Verfahren der Fall sein, dass mit diesem Verfahren nur eine Materialzusammensetzung, nämlich die der Matrix 31, aufgebracht werden kann. In diesem Fall wird die Zweitphase über eine separate Nebendüse 40 (Fig. 4) in die Schicht 25, 28 eingebracht.

Figur 4 zeigt schematisch eine Beschichtungsvorrichtung, mit der eine Zweitphase und ein Matrixmaterial 31 aufgebracht wird.

Mittels einer Hauptdüse 37, die beispielsweise eine Brennerdüse einer Plasmabeschichtungsanlage ist, oder eines Substrats 37 einer PVD-Anlage, wird das Matrixmaterial 31 auf das Substrat 22 oder die zumindest eine Zwischenschicht 25 aufgebracht.

Mittels einer separaten Quelle bspw. einer Nebendüse 40 wird die Zweitphase 34 in den Partikelstrom des Matrixmaterials 31 beigemischt, so dass sich eine Matrix 31 mit einer Zweitphase, die einen Volumenanteil kleiner 50% aufweist, bildet.

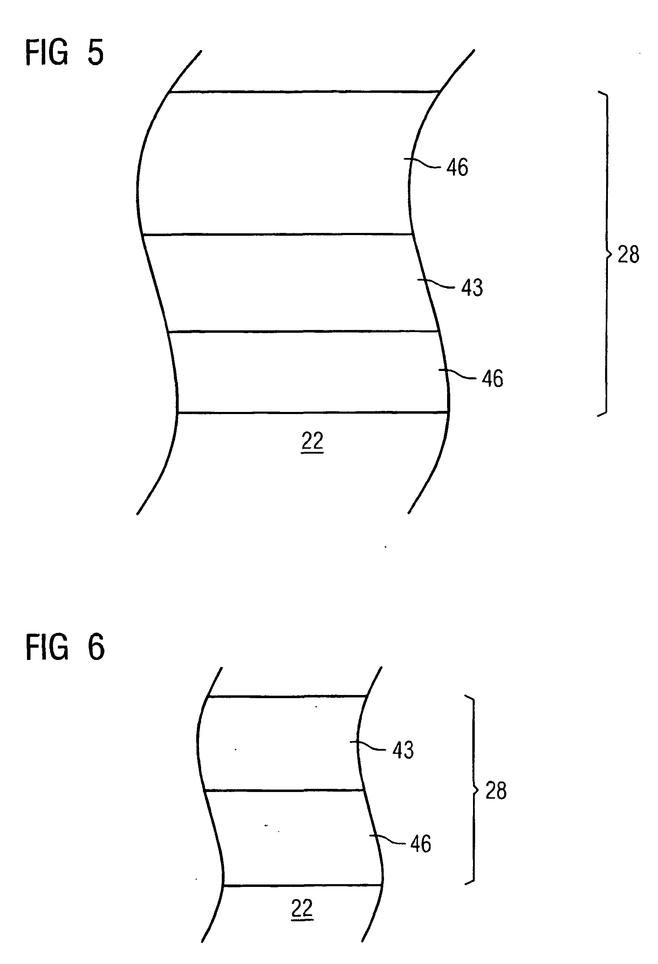

Figur 5 zeigt eine Schicht eines erfindungsgemäßen Wärmedämmschichtsystems.
Die Schicht 28 ist zumindest zweilagig und besteht aus zwei Schichten 46, die nicht verstärkt sind, und einer Schicht 43, die durch eine Zweitphase verstärkt ist.
Die erste Schicht 46 liegt bspw. auf dem Substrat 22 oder der Schicht 25 auf. Dann folgt die Schicht 43 und als äußere Schicht die unverstärkte Schicht 46.
Risse können nicht oder nur schwer durch die Schicht 43 hindurchwachsen, so dass ein Ablösen der Schicht 28 vom Substrat 22 verhindert wird.

Figur 6 zeigt eine Schicht eines erfindungsgemäßen Wärmedämmschichtsystems.
Die Schicht 28 ist zweilagig und besteht aus einer Schicht 46, die nicht verstärkt ist, und einer Schicht 43, die durch eine Zweitphase verstärkt ist.
Die erste Schicht 43 liegt bspw. auf dem Substrat 22 oder der Schicht 25 auf. Dann folgt die Schicht 43 als äußere Schicht oder umgekehrt.
Risse können nicht oder nur schwer durch die Schicht 43 hindurchwachsen, so dass ein Ablösen der Schicht 28 vom Substrat 22 verhindert wird.

## Patentansprüche

1. Wärmedämmschichtsystem (19),
bestehend aus einem Substrat (22) und
zumindest einer darauf aufliegenden Schicht (25, 28),
**dadurch gekennzeichnet, dass**
die zumindest eine Schicht (25, 28) eine Zweitphase (34) in einem Matrixmaterial (31) aufweist, das eine Zusammensetzung ausgewählt aus der Gruppe La-Al-O, Sr-Ca-Zr-O, Gd-La-Al-O aufweist, um die mechanischen Eigenschaften zu verbessern.

2. Wärmedämmschichtsystem nach Anspruch 1,
**dadurch gekennzeichnet, dass**
die Zweitphase (34) durch Partikel gebildet ist, so dass eine Partikelverstärkung der Schicht (25, 28) auftritt.

3. Wärmedämmschichtsystem nach Anspruch 2,
**dadurch gekennzeichnet, dass**
die Partikel (34) eine längliche Form aufweisen.

4. Wärmedämmschichtsystem nach Anspruch 1 oder 2,
**dadurch gekennzeichnet, dass**
die Zweitphase (34) eine Faser ist.

5. Wärmedämmschichtsystem nach Anspruch 1,
**dadurch gekennzeichnet, dass**
die zumindest eine Schicht (25, 28) eine keramische Schicht ist.

6. Wärmedämmschichtsystem nach Anspruch 1,
**dadurch gekennzeichnet, dass**
die Schicht (25, 28) eine Wärmedämmschicht (28) ist.

7. Wärmedämmschichtsystem nach Anspruch 1,
**dadurch gekennzeichnet, dass**
die Zweitphase (34) die Zusammensetzung LaAl₁₁O₁₈ aufweist.

8. Wärmedämmschichtsystem nach Anspruch 1,
**dadurch gekennzeichnet, dass**
die Schicht (25, 28) eine metallische Schicht, insbesondere eine MCrAlY-Schicht (25) ist.

9. Wärmedämmschichtsystem nach Anspruch 1,
**dadurch gekennzeichnet, dass**
das Lanthan in dem Matrixmaterial oder Material der Zweitphase durch andere Lanthanide ersetzt sind.

10. Wärmedämmschichtsystem nach Anspruch 1,
**dadurch gekennzeichnet, dass**
das Wärmdämmschichtsystem (19) eine Turbinenschaufel (1) darstellt.

11. Wärmedämmschichtsystem nach Anspruch 1,
**dadurch gekennzeichnet, dass**
die Wärmedämmschicht (28) zumindest zweilagig ist.

12. Wärmedämmschichtsystem nach Anspruch 11,
**dadurch gekennzeichnet, dass**
ein äußerer Schichtteil der Wärmedämmschicht (28) die Zweitphase aufweist.

13. Wärmedämmschichtsystem nach Anspruch 11,
**dadurch gekennzeichnet, dass**
ein innerer Schichtteil der Wärmedämmschicht die Zweitphase (34) aufweist.

14. Wärmedämmschichtsystem nach Anspruch 1,
**dadurch gekennzeichnet, dass**
die Zweitphase (34) nur lokal vorhanden ist.

## Claims

1. Thermal barrier coating system (19), comprising a substrate (22) and at least one layer (25, 28) applied thereto, **characterized in that** the at least one layer (25, 28) has a second phase (34) in a matrix material (31) which has a composition selected from the group consisting of La-Al-O, Sr-Ca-Zr-O, Gd-La-Al-O, in order to improve the mechanical properties.

2. Thermal barrier coating system according to Claim 1, **characterized in that** the second phase (34) is formed by particles, so that the layer (25, 28) is particle-reinforced.

3. Thermal barrier coating system according to Claim 2, **characterized in that** the particles (34) are elongate in form.

4. Thermal barrier coating system according to Claim 1 or 2, **characterized in that** the second phase (34) is a fibre.

5. Thermal barrier coating system according to Claim 1, **characterized in that** the at least one layer (25, 28) is a ceramic layer.

6. Thermal barrier coating system according to Claim 1, **characterized in that** the layer (25, 28) is a thermal barrier coating (28).

7. Thermal barrier coating system according to Claim 1, **characterized in that** the second phase (34) has the composition LaAl₁₁O₁₈.

8. Thermal barrier coating system according to Claim 1, **characterized in that** the layer (25, 28) is a metallic layer, in particular a MCrAlY layer (25).

9. Thermal barrier coating system according to Claim 1, **characterized in that** the lanthanum in the matrix material or material of the second phase is replaced by other lanthanides.

10. Thermal barrier coating system according to Claim 1, **characterized in that** the thermal barrier coating system (19) forms a turbine blade or vane (1).

11. Thermal barrier coating system according to Claim 1, **characterized in that** the thermal barrier coating (28) comprises at least two layers.

12. Thermal barrier coating system according to Claim 11, **characterized in that** an outer layer part of the thermal barrier coating (28) includes the second phase.

13. Thermal barrier coating system according to Claim 11, **characterized in that** an inner layer part of the thermal barrier coating includes the second phase (34).

14. The thermal barrier coating system according to Claim 1, **characterized in that** the second phase (34) is only locally present.

## Revendications

1. Système (19) stratifié calorifuge,
constitué d'un substrat (22) et
d'au moins une couche (25, 28) se trouvant dessus,
**caractérisé en ce que**
la au moins une couche (25, 28) a une deuxième phase (34)
dans un matériau (31) servant de matrice et ayant une composition choisie dans le groupe La-Al-O, Sr-Ca-Zr-O, Gd-La-Al-O
pour améliorer les propriétés mécaniques.

2. Système stratifié calorifuge suivant la revendication 1,
**caractérisé en ce que**
la deuxième phase (34) est formée de particules, de manière à produire un renforcement de la couche (25, 28) par des particules.

3. Système stratifié calorifuge suivant la revendication 2,
**caractérisé en ce que**
les particules (34) ont une forme oblongue.

4. Système stratifié calorifuge suivant la revendication 1 ou 2,
**caractérisé en ce que**
la deuxième phase (34) est une fibre.

5. Système stratifié calorifuge suivant la revendication 1,
**caractérisé en ce que**
la au moins une couche (25, 28) est une couche en céramique.

6. Système stratifié calorifuge suivant la revendication 1,
**caractérisé en ce que**
la couche (25, 28) est une couche (28) calorifuge.

7. Système stratifié calorifuge suivant la revendication 1,
**caractérisé en ce que**
la deuxième phase (34) a la composition LaAl₁₁O₁₈.

8. Système stratifié calorifuge suivant la revendication 1,
**caractérisé en ce que**
la couche (25, 28) est une couche métallique, notamment une couche (25) en MCrAlY.

9. Système stratifié calorifuge suivant la revendication 1,
**caractérisé en ce que**
le lanthane dans le matériau de la matrice ou dans le matériau de la deuxième phase est remplacé par d'autres lanthanides.

10. Système stratifié calorifuge suivant la revendication 1,
**caractérisé en ce que**
le système (19) stratifié calorifuge constitue une aube (1) de turbine.

11. Système stratifié calorifuge suivant la revendication 1,
**caractérisé en ce que**
la couche (28) calorifuge est au moins à deux strates.

12. Système stratifié calorifuge suivant la revendication 11,
**caractérisé en ce que**
une partie extérieure de la couche (28) calorifuge comporte la deuxième phase.

13. Système stratifié calorifuge suivant la revendication 11,
**caractérisé en ce que**
une partie intérieure de la couche calorifuge comporte la deuxième phase (34).

14. Système stratifié calorifuge suivant la revendication 1,
**caractérisé en ce que**
la deuxième phase (34) n'est présente que localement.
